(19) **Europäisches Patentamt**
**European Patent Office**
**Office européen des brevets**

(11) **EP 4 474 442 A1**

(12) **EUROPEAN PATENT APPLICATION**
published in accordance with Art. 153(4) EPC

(43) Date of publication:
**11.12.2024 Bulletin 2024/50**

(51) International Patent Classification (IPC):
*C09J 163/00* (2006.01)     *C09J 11/04* (2006.01)
*C08L 61/04* (2006.01)     *C08L 33/20* (2006.01)
*C08L 71/00* (2006.01)     *H01L 21/683* (2006.01)

(21) Application number: 23904768.1

(22) Date of filing: 08.11.2023

(86) International application number:
**PCT/KR2023/017806**

(87) International publication number:
**WO 2024/219577 (24.10.2024 Gazette 2024/43)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **18.04.2023 KR 20230050688**

(71) Applicant: **LG Chem, Ltd.**
**Yeoui-daero, Youngdungpo-gu**
**Seoul 07336 (KR)**

(72) Inventors:
• **JEONG, Minsu**
**Daejeon 34122 (KR)**

• **KIM, Junghak**
**Daejeon 34122 (KR)**
• **NAM, Seunghee**
**Daejeon 34122 (KR)**
• **CHO, Eunbyurl**
**Daejeon 34122 (KR)**
• **KIM, Kibeom**
**Daejeon 34122 (KR)**

(74) Representative: **Goddar, Heinz J.**
**Boehmert & Boehmert**
**Anwaltspartnerschaft mbB**
**Pettenkoferstrasse 22**
**80336 München (DE)**

(54) **NON-CONDUCTIVE FILM, SEMICONDUCTOR DEVICE AND MANUFACTURING METHOD THEREOF**

(57)     The present invention relates to a non-conductive film, a semiconductor device and a manufacturing method of the same. The non-conductive film can effectively prevent generation of voids during the semiconductor manufacturing process and sufficiently adhere to the semiconductor element, thereby providing a semiconductor device having excellent reliability.

**Description**

**[TECHNICAL FIELD]**

CROSS-REFERENCE TO RELATED APPLICATION(S)

This application claims the benefit of Korean Patent Application No. 10-2023-0050688 filed on April 18, 2023 with the Korean Intellectual Property Office, the disclosure of which is incorporated herein by reference in its entirety.

The present invention relates to a non-conductive film, a semiconductor device and a manufacturing method of the same.

**[BACKGROUND]**

Recently, as the trend toward miniaturization, higher functionality, and larger capacity of electronic devices has expanded, the need for higher density and higher integration of semiconductor packages is rapidly increasing.

In response to such demands, a flip chip mounting method has been introduced in which semiconductor elements such as semiconductor chips are directly connected onto a substrate. In the flip chip mounting method, a semiconductor chip is electrically connected with other semiconductor chips, wiring boards, etc. through a solder bump or the like formed on the semiconductor chip. At this time, an underfill material is filled between the bonding surfaces in order to reinforce the bonding position and improve bonding reliability.

As such an underfill filling method, a capillary underfilling method is known. However, the capillary underfilling method has a fundamental problem that it is difficult to uniformly inject the underfill material into the fine space between electrodes in a short period of time. Further, in recent years, as the pitch between electrodes becomes narrower and the thickness of semiconductor chips becomes thinner, the capillary underfilling method has its limits in providing a sealing layer with uniform thickness.

Thus, a method using a non-conductive film has been developed. According to the method, a non-conductive film is formed or attached to an element formation surface of a semiconductor wafer, the semiconductor wafer is diced and individualized into semiconductor chips, then the individualized semiconductor chips are mounted on a substrate, and metal bonding and sealing are performed simultaneously.

This metal bonding and sealing are mainly performed by thermocompression bonding (TCB) method. The thermocompression bonding method can be performed by applying pressure at a temperature of about 200 to 300°C for a short time period of about 2 to 10 seconds. Since the thermocompression bonding method involves rapid changes in temperature and pressure, there is a problem that voids are easily generated in the sealing layer formed of a non-conductive film. However, if voids remain in the sealing layer without being removed, it will adversely affect the reliability of the semiconductor device.

**[DETAILED DESCRIPTION OF THE INVENTION]**

**[Technical Problem]**

It is an object of the present invention to provide a non-conductive film that prevents generation of voids during the semiconductor manufacturing process.

It is another object of the present invention to provide a semiconductor device comprising the non-conductive film.

It is yet another object of the present invention to provide a manufacturing method of the semiconductor device.

**[Technical Solution]**

Now, a non-conductive film, a semiconductor device, a method of manufacturing the semiconductor device, and the like according to specific embodiments of the invention will be described.

According to one embodiment of the invention, there is provided a non-conductive film comprising: an adhesive layer comprising a thermoplastic resin, a thermosetting resin, a curing agent and an inorganic filler, wherein the adhesive layer has a Y of the following Equation 1 that is more than 0 and 3 or less:

$$[\text{Equation 1}]$$

$$Y = (\triangle T * G)^2/(5.88 * \eta)$$

wherein, in Equation 1,

$\Delta T$ is the difference between the heat generation start temperature and the maximum heat generation temperature of the adhesive layer measured by differential scanning calorimetry at a temperature increase rate of 10°C/min and a temperature of 30°C to 300°C, G is the gelling time at 200°C measured in seconds for the adhesive layer, and $\eta$ is the minimum melt viscosity measured in units of Pa·s for the adhesive layer.

The non-conductive film of one embodiment may be a non-conductive film before being used in the semiconductor manufacturing process, a non-conductive film applied during the semiconductor manufacturing process, or a non-conductive film included in the final semiconductor device.

The non-conductive film before being used in the semiconductor manufacturing process may mean a film containing a B-staged adhesive layer applied onto a substrate. In one example, a non-conductive film before being used in the semiconductor manufacturing process may be a die attach film in which a substrate and an adhesive layer are laminated, or a dicing die bonding film in which a substrate, a pressure-sensitive adhesive layer, and an adhesive layer are sequentially laminated.

The non-conductive film applied during the semiconductor manufacturing process may mean a B-staged adhesive layer applied onto a semiconductor element. In other words, the non-conductive film may be applied onto a substrate, produced in the form of a film, and then attached to a semiconductor element, but may be produced in a film shape by applying an adhesive composition to a semiconductor element.

The non-conductive film included in the final semiconductor device may mean a cured adhesive layer found in a final semiconductor device manufactured through a semiconductor manufacturing process. The cured adhesive layer may be a sealing layer that seals the semiconductor element.

In Equation 1, the value calculated in units of °C is substituted into $\Delta T$, the value measured in seconds (sec) is substituted into G, and the value measured in units of Pa·s is substituted into $\eta$. However, by omitting the units and substituting only numerical values, Y in Equation 1 can be calculated as a value without units.

When a non-conductive film containing an adhesive layer in which Y calculated by Equation 1 is 3 or less is used in a semiconductor manufacturing process, voids are not easily generated, and a semiconductor device having excellent reliability can be provided. In particular, a non-conductive film containing an adhesive layer in which Y calculated by Equation 1 is 3 or less can effectively prevent generation of voids even in the thermocompression bonding process of the flip chip mounting method, where voids are easily generated, thereby providing a semiconductor device having excellent reliability.

The adhesive layer used for bonding members of a semiconductor device having different coefficients of linear expansion, etc. (e.g., a wiring board and a semiconductor chip, different semiconductor chips, etc.) needs to protrude sufficiently around the bonded members to form a fillet in order to disperse stress in the members due to temperature changes and improve reliability. A non-conductive film containing an adhesive layer in which Y calculated by Equation 1 is 3 or less can form a fillet in an amount suitable for ensuring the reliability of the semiconductor device, and particularly, can effectively prevent generation of voids in the fillet.

$\Delta T$ in Equation 1 is the difference between the heat generation start temperature and the maximum heat generation temperature of the adhesive layer. For specific measurement methods of $\Delta T$, refer to the details described in the Test Examples described later.

The $\Delta T$ may be a value determined according to the gel time and the minimum melt viscosity so that Y in Equation 1 is 3 or less. In one example, $\Delta T$ may be 1°C to 20°C. More specifically, $\Delta T$ may be 1°C or more, 2°C or more, 3°C or more, 4°C or more, 5°C or more, 6°C or more, or 7°C or more, and 20°C or less, 15°C or less, 14°C or less, 13°C or less, 12°C or less, 11°C or less, or 10°C or less. As the adhesive layer is cured at an appropriate rate in the thermocompression bonding process within this range, it is possible to prevent additional voids from being generated inside while ensuring sufficient time for voids to escape.

G in Equation 1 is the gelling time of the adhesive layer at 200°C. G is the gelling time of the B-staged adhesive layer, and for specific measurement methods, refer to the details described in the Test Examples described later.

The G may be a value determined according to the $\Delta T$ and the minimum melt viscosity so that Y in Equation 1 is 3 or less. In one example, G can be between 5 seconds and 30 seconds. More specifically, G may be 5 seconds or more, 6 seconds or more, 7 seconds or more, and 30 seconds or less, 20 seconds or less, 10 seconds or less, 9 seconds or less, 8.5 seconds or less, 8.3 seconds or less, 8.2 seconds or less, or 8.14 seconds or less. As the adhesive layer is cured at an appropriate rate in the thermocompression bonding process within this range, it is possible to prevent additional voids from being generated inside while ensuring sufficient time for voids to escape.

$\eta$ in Equation 1 is the minimum melt viscosity of the adhesive layer. For specific measurement methods of $\eta$, refer to the details described in the Test Examples described later.

The $\eta$ may be a value determined according to the $\Delta T$ and the gel time so that Y in Equation 1 is 3 or less. In one example, $\eta$ may be between 10 Pa·s and 5000 Pa·s. More specifically, $\eta$ may be 10 Pa·s or more, 50 Pa·s or more, 100 Pa·s or more, 150 Pa·s or more, 200 Pa·s or more, 250 Pa·s or more, 300 Pa·s or more, 350 Pa·s or more or 400 Pa·s or more, and 5000 Pa·s or less, 4000 Pa·s or less, 3000 Pa·s or less, 2000 Pa·s or less, 1000 Pa·s or less, 900 Pa·s or less, 800 Pa·s or less or 700 Pa·s or less. Within this range, the adhesive layer can exhibit appropriate fluidity to sufficiently embed the semiconductor element in a state where voids are unlikely to generate.

Y in Equation 1 is a factor related to the generation of voids due to the adhesive layer during the semiconductor manufacturing process, and when Y has a value of 3 or less, it is possible to effectively suppress the generation of voids. More specifically, Y in Equation 1 may be 3 or less, 2.5 or less, 2 or less, 1.9 or less, 1.8 or less, 1.7 or less, 1.6 or less, or 1.5 or less. Y in Equation 1 is a value of more than 0, and for example, it may be 0.00001 or more, 0.001 or more, 0.001 or more, 0.1 or more, 0.5 or more, 0.8 or more, or 1 or more.

The adhesive layer according to one embodiment may include a thermoplastic resin, a thermosetting resin, a curing agent, and an inorganic filler.

The adhesive layer according to one embodiment is a thermoplastic resin, and may include two or more thermoplastic resins having different glass transition temperatures. In this case, it is advantageous to provide an adhesive layer in which Y in Equation 1 is 3 or less.

Specifically, the thermoplastic resin may include a first thermoplastic resin having a glass transition temperature of -10°C to 50°C and a second thermoplastic resin having a glass transition temperature of more than 50°C and 100°C or less.

The type of the first thermoplastic resin is not particularly limited, and examples thereof may include one or more resins selected from the group consisting of polyimide-based resin, polyether imide-based resin, polyester imide-based resin, polyamide-based resin, polyether sulfone-based resin, polyether ketone-based resin, polyolefin-based resin, polyvinyl chloride-based resin, phenoxy-based resin, butadiene-based rubber, styrene-butadiene-based rubber, modified butadiene-based rubber, reactive butadiene acrylonitrile copolymer rubber and (meth)acrylate-based resin.

In one example, the first thermoplastic resin may include (meth)acrylate-based resin. The (meth)acrylate-based resin may be a (co)polymer produced from one or more monomers selected from the group consisting of an alkyl (meth) acrylate having 1 to 12 carbon atoms, a (meth)acrylate containing a reactive functional group, acrylonitrile and a vinyl-based monomer polymerizable therewith. The alkyl (meth)acrylate having 1 to 12 carbon atoms may include, for example, ethyl (meth)acrylate, propyl (meth)acrylate, butyl (meth)acrylate, pentyl (meth)acrylate, hexyl (meth)acrylate, heptyl (meth)acrylate or octyl (meth)acrylate (ethylhexyl (meth)acrylate), etc. The (meth)acrylate containing a reactive functional group may include, for example, a monomer containing at least one of an epoxy group, a hydroxyl group, and a carboxyl group. Specifically, the (meth)acrylate containing a reactive functional group may include glycidyl (meth)acrylate. The vinyl monomer may include, for example, styrene, and the like.

In one example, the first thermoplastic resin may be a first copolymer produced from an alkyl (meth)acrylate having 1 to 12 carbon atoms, a (meth)acrylate containing an epoxy group, and acrylonitrile.

The first copolymer may include, for example, a repeating unit of an alkyl (meth)acrylate having 1 to 12 carbon atoms in an amount of 30 to 99% by weight, 50 to 97% by weight, or 60 to 95% by weight based on the total repeating units. The first copolymer may include, for example, a repeating unit containing an epoxy group in an amount of 0.1 to 30% by weight, 0.1 to 20% by weight, 0.1 to 10% by weight, or 0.1 to 7% by weight based on the total repeating units. The first copolymer may include, for example, a repeating unit of acrylonitrile in an amount of 1 to 60% by weight, 5 to 50% by weight, or 7 to 35% by weight based on the total repeating units.

The weight average molecular weight of the first thermoplastic resin may be 50,000 to 1,000,000 g/mol.

The glass transition temperature of the first thermoplastic resin may be -10°C or more, -8°C or more, or -6°C or more, and 50°C or less, 45°C or less, or 42°C or less. Within this range, it can be combined with a second thermoplastic resin, thereby allowing Y in Equation 1 to have a lower value.

The type of the second thermoplastic resin is not particularly limited, but may include, for example, one or more resins selected from the group consisting of polyimide-based resin, polyether imide-based resin, polyester imide-based resin, polyamide-based resin, polyether sulfone-based resin, polyether ketone-based resin, polyolefin-based resin, polyvinyl chloride-based resin, phenoxy-based resin, butadiene-based rubber, styrene-butadiene-based rubber, modified butadiene-based rubber, reactive butadiene acrylonitrile copolymer rubber and (meth)acrylate-based resin.

In one example, the second thermoplastic resin may include one or more resins selected from the group consisting of (meth)acrylate-based resin and phenoxy-based resin.

The (meth)acrylate-based resin may be a (co)polymer produced from one or more monomers selected from the group consisting of an alkyl (meth)acrylates having 1 to 12 carbon atoms, a (meth)acrylates containing a reactive functional group, acrylonitrile, and a vinyl-based monomer polymerizable therewith. The alkyl (meth)acrylates having 1 to 12 carbon atoms may include, for example, ethyl (meth)acrylate, propyl (meth)acrylate, butyl (meth)acrylate, pentyl (meth) acrylate, hexyl (meth)acrylate, heptyl (meth)acrylate, octyl (meth)acrylate (ethylhexyl (meth)acrylate), or the like. The (meth)acrylates containing a reactive functional group may include, for example, a monomer containing at least one of an epoxy group, a hydroxyl group, and a carboxyl group. Specifically, the (meth)acrylate containing a reactive functional group may include glycidyl (meth)acrylate. The vinyl monomer may include, for example, styrene, and the like.

In one example, the second thermoplastic resin may include a second copolymer produced from an alkyl (meth) acrylate having 1 to 12 carbon atoms, a (meth)acrylate containing an epoxy group, acrylonitrile and styrene.

The second copolymer may include, for example, a repeating unit of an alkyl (meth)acrylate having 1 to 12 carbon atoms in an amount of 20 to 60% by weight or 30 to 50% by weight based on the total repeating units. The second copolymer may include, for example, a repeating unit containing an epoxy group in an amount of 0.1 to 30% by weight, 0.1 to 20% by weight, 0.1 to 10% by weight, or 0.1 to 7% by weight based on the total repeating units. The second copolymer may include, for example, a repeating unit of acrylonitrile in an amount of 5 to 60% by weight, 10 to 50% by weight, or 20 to 40% by weight based on the total repeating units. The second copolymer may include a repeating unit of styrene in an amount of 5 to 50% by weight, 10 to 40% by weight, or 20 to 30% by weight.

In another example, the second thermoplastic resin may include phenoxy-based resins such as bisphenol A-type phenoxy resin, bisphenol F-type phenoxy resin, bisphenol A/F-type phenoxy resin, and fluorene-based phenoxy resin. A commercially available phenoxy-based resin such as YP-50 (from Kukdo Chemical) can be used.

The weight average molecular weight of the second thermoplastic resin may be 10,000 to 1,000,000 g/mol.

The glass transition temperature of the second thermoplastic resin may be more than 50°C, 55°C or more, or 60°C or more, and 100°C or less, 90°C or less, 85°C or less, 80°C or less, 75°C or less, or 70°C or less. Within this range, it can be combined with the first thermoplastic resin, thereby allowing Y in Equation 1 to have a lower value.

The thermoplastic resin may be contained in an amount of 1 to 30% by weight based on the total solid content of the adhesive layer. Specifically, the thermoplastic resin may be contained in an amount of 1% by weight or more, 3% by weight or more, 5% by weight or more, or 7% by weight or more, and 30% by weight or less, 20% by weight or less, 15% by weight or less, or 12% by weight or less, based on the total solid content of the adhesive layer. Within this range, it is advantageous to provide an adhesive layer in which a semiconductor element can be embedded without generating voids in the semiconductor manufacturing process.

The first and second thermoplastic resins may be contained in a weight ratio of 1:10 to 1:0.1, 1:5 to 1:0.2, 1:2 to 1:0.5, or 1:1.2 to 1:0.8. Within this range, it is advantageous to provide an adhesive layer in which Y in Formula 1 is 3 or less.

The thermosetting resin may react with a curing agent to exhibit heat resistance or mechanical strength.

The thermosetting resin may include an epoxy resin. The type of the epoxy resin is not particularly limited, but may include one or more resins selected from the group consisting of cresol novolac epoxy resin, bisphenol F-type epoxy resin, bisphenol F type novolac epoxy resin, bisphenol A type epoxy resin, bisphenol A type novolac epoxy resin, phenol novolac epoxy resin, tetrafunctional epoxy resin, biphenyl type epoxy resin, biphenyl type novolac epoxy resin, triphenol methane type epoxy resin, alkyl-modified triphenol methane type epoxy resin, naphthalene type epoxy resin, dicyclopentadiene type epoxy resin, dicyclopentadiene modified phenol type epoxy resin, glycidylamine type epoxy resin and cycloaliphatic epoxy resin.

The thermosetting resin may include a liquid epoxy resin and a solid epoxy resin. In this case, the resin can easily adjust the degree of curing of the adhesive layer, can further improve the adhesive performance, and has appropriate fluidity, which may be advantageous for allowing Y in Equation 1 to have a value of 3 or less.

The liquid epoxy resin is not particularly limited in its physical properties, but for example, it may have a viscosity of 500 mPa·s to 20,000 mPa·s at 25°C. The liquid epoxy resin may have an epoxy equivalent weight of 100 to 1000 g/eq.

The solid epoxy resin is not particularly limited in its physical properties, but may have a softening point of, for example, 50°C to 120°C. The solid epoxy resin may have an epoxy equivalent weight of 100 to 1000 g/eq.

The thermosetting resin may be contained in an amount of 5 to 50% by weight based on the total solid content of the adhesive layer. Specifically, the thermosetting resin may be contained in an amount of 5% by weight or more, 10% by weight or more, or 15% by weight or more, and 50% by weight or less, 40% by weight or less, or 35% by weight or less, based on the total solid content of the adhesive layer. Within this range, it is advantageous to provide an adhesive layer in which a semiconductor element can be embedded without generating voids in the semiconductor manufacturing process.

The liquid epoxy resin and the solid epoxy resin may be contained in a weight ratio of 1:10 to 1:0.1, 1:5 to 1:0.2, 1:2 to 1:0.5, or 1:2 to 1:1.2. Within this range, the adhesive layer has sufficient adhesion to the semiconductor element, and it is advantageous to provide an adhesive layer in which Y in Equation 1 is 3 or less.

The type of the curing agent is not particularly limited, but may include, for example, at least one of an amine-based compound, an acid anhydride-based compound, an amide-based compound, and a phenol-based compound. Specifically, the amine-based compound may be one or more selected from the group consisting of diaminodiphenylmethane, diethylenetriamine, triethylenetetraamine, diaminodiphenylsulfone and isophoronediamine. The acid anhydride-based compound may be one or more selected from the group consisting of phthalic anhydride, trimellitic anhydride, pyromellitic anhydride, maleic anhydride, tetrahydrophthalic anhydride, methyltetrahydrophthalic anhydride, methylnadic anhydride, hexahydrophthalic anhydride and methylhexahydrophthalic anhydride. The amide-based compound may be a polyamide resin synthesized from dicyandiamide, a dimer of linolenic acid, and ethylenediamine. The phenol-based compound may be polyhydric phenols such as bisphenol A, bisphenol F, bisphenol S, fluorenebisphenol, and terpenediphenol; phenol resins obtained by condensation of phenols with aldehydes, ketones, or dienes; modified products of phenols and/or phenol resins; halogenated phenols such as tetrabromobisphenol A and brominated phenol resin; other imidazoles, BF3-amine complexes, guanidine derivatives. By selecting the curing agent from those listed above, the degree of curing of the thermosetting resin can be adjusted and the mechanical properties of the adhesive can be improved.

In one example, the curing agent may include a phenol-based compound. The phenol-based compound may have a softening point of 60°C or more, 80°C or more, or 100°C or more and 160°C or less or 150°C or less. A phenol-based compound having a softening point in this range allows the adhesive layer to have a higher tensile modulus at room temperature, and has flow characteristics that are advantageous for embedding semiconductor elements.

The curing agent may be contained in an amount of 1 to 30% by weight based on the total solid content of the adhesive layer. Specifically, the curing agent may be contained in an amount of 1% by weight or more, 5% by weight or more, or 10% by weight or more, and 30% by weight or less, 25% by weight or less, or 20% by weight or less, based on the total solid content of the adhesive layer. Within this range, a phenomenon in which the adhesive layer flows during the semiconductor manufacturing process can be prevented, and the generation of voids can be effectively prevented.

The type of the inorganic filler is not particularly limited, but may include, for example, one or more selected from the group consisting of silica, titanium dioxide, aluminum hydroxide, calcium carbonate, magnesium hydroxide, aluminum oxide, talc and aluminum nitride. By using the above-mentioned types of inorganic fillers, it is possible to improve the adhesion of the adhesive layer and prevent cracks in the semiconductor package.

The average particle diameter of the inorganic filler may be 0.03 $\mu$m to 3 $\mu$m. Specifically, the average particle diameter of the inorganic filler may be 0.04 $\mu$m or more or 0.05 $\mu$m or more, and 2.5 $\mu$m or less or 2 $\mu$m or less. When the average particle diameter of the inorganic filler is within the above-mentioned range, the degree of dispersion of the inorganic filler in the adhesive layer can be improved.

The inorganic filler may be contained in an amount of 20 to 60% by weight based on the total solid content of the adhesive layer. Specifically, the inorganic filler may be contained in an amount of 20% by weight or more, 30% or more, or 35% by weight or more, and 60% by weight or less, 55% by weight or less, or 50% by weight or less based on the total solid content of the adhesive layer. Within this range, the mechanical properties of the adhesive layer can be improved, the mismatch in thermal expansion coefficient with the semiconductor chip can be reduced, and reliability can be improved.

The adhesive layer may further include a curing catalyst. Specifically, the curing catalyst may be one selected from the group consisting of phosphorus-based compounds, boron-based compounds, phosphorus-boron-based compounds, imidazole-based compounds, and combinations thereof, but is not limited thereto. By using the curing catalyst, the action of the curing agent and the curing of the adhesive layer can be promoted. Further, the amount of the curing catalyst used can be appropriately selected in consideration of the physical properties of the adhesive layer to be finally manufactured.

The adhesive layer may further include known additives, if necessary. For example, the adhesive layer may further include a coupling agent, a leveling agent, a dispersant, or a combination thereof.

The thickness of the adhesive layer may vary depending on the height of the semiconductor element to which the non-conductive film is to be applied. As a nonlimiting example, the thickness of the adhesive layer may be controlled to be 1 $\mu$m or more or 5 $\mu$m or more and 500 $\mu$m or less, 100 ,um or less, or 50 ,um or less.

On the other hand, according to another embodiment of the invention, there is provided a semiconductor device comprising a non-conductive film and a semiconductor element, wherein the semiconductor element is embedded by the adhesive layer. The non-conductive film may be the non-conductive film according to the above embodiment.

The type of the semiconductor element is not particularly limited, but may include, for example, a bump that can be used in a flip chip mounting method.

The semiconductor device of another embodiment can be manufactured by a process in which an adhesive layer is formed onto a bump formation surface of the semiconductor element or an adhesive layer is attached thereto, a dicing process is performed if necessary, and then a semiconductor element is mounted at a position to be connected, and metal bonding and sealing can be simultaneously performed using a thermocompression bonding method.

As mentioned above, as Y calculated by Equation 1 has a value of 3 or less, even when the adhesive layer is applied to a thermocompression bonding method, it does not easily generate voids and also can effectively embed electrodes with a fine pitch to provide a semiconductor device having excellent reliability.

On the other hand, according to another embodiment of the invention, there is provided a method of manufacturing a semiconductor device, the method comprising the steps of: calculating Y in Equation 1 for a non-conductive film containing an adhesive layer and selecting the non-conductive film containing an adhesive layer in which Y is more than 0 and 3 or less; and applying the selected non-conductive film to an element formation surface of a semiconductor element.

As mentioned above, when a non-conductive film containing an adhesive layer where Y calculated by Equation 1 is 3 or less is used in the semiconductor manufacturing process, it does not easily generate voids and also can effectively embed electrodes with a fine pitch to provide a semiconductor device having excellent reliability.

In the semiconductor device manufacturing method, Y in Equation 1 is calculated before the semiconductor device manufacturing process to predict in advance whether or not voids occur in the non-conductive film, and non-conductive films that are unlikely to generate voids can be selected, and applied in the semiconductor manufacturing process.

In one example, in the semiconductor device manufacturing method, a non-conductive film can be prepared in the form of a die adhesive film in which an adhesive layer is laminated on a substrate, or a dicing die bonding film in which a pressure-sensitive adhesive layer and an adhesive layer are sequentially laminated on a substrate. Then, an adhesive layer is attached to the element formation surface of the semiconductor element, and if the non-conductive film is a dicing die bonding film, the dicing process is performed, and the semiconductor element is mounted at the position to be connected, and metal bonding and sealing are performed simultaneously using a thermocompression bonding method, thereby being able to manufacture a semiconductor device.

In another example, in the method of manufacturing a semiconductor device, the above-mentioned adhesive layer can be formed on the element formation surface of the semiconductor element to form a non-conductive film. Then, after going through a dicing process as necessary, the semiconductor element can be mounted at a position to be connected, and metal bonding and sealing can be simultaneously performed using a thermocompression bonding method to manufacture a semiconductor device.

The conditions of the thermocompression bonding process are not particularly limited. In one example, the thermocompression bonding process may be performed by applying a pressure of 30 to 150 N at a temperature of about 50°C to 150°C for 2 to 10 seconds, and then heating at a temperature of about 200°C to 300°C for 2 seconds to 10 seconds.

The non-conductive film used in the semiconductor device manufacturing method is selected to be less likely to generate voids through Equation 1, and thus, even if the thermocompression bonding process is performed under the above conditions, voids are not easily generated, thereby making it possible to provide a semiconductor device having excellent reliability.

**[Advantageous Effects]**

The non-conductive film according to one embodiment can effectively prevent generation of voids during the semiconductor manufacturing process and sufficiently adhere to the semiconductor element to provide a semiconductor device having excellent reliability.

**[DETAILED DESCRIPTION OF THE EMBODIMENTS]**

Hereinafter, the action and effect of the invention will be described in more detail with reference to specific examples of the invention. However, these examples are presented for illustrative purposes only, and the scope of the invention is not limited thereby in any way.

Preparation Example 1: Preparation of thermoplastic resin

59 g of n-butyl acrylate, 10 g of acrylonitrile, 3 g of glycidyl methacrylate, and 28 g of isobutyl methacrylate were added to 100 g of toluene. Then, the obtained reaction product was reacted at 80°C for about 12 hours to synthesize an acrylate-based resin into which a glycidyl group was introduced (weight average molecular weight: about 500,000, glass transition temperature: -5°C).

Preparation Example 2: Preparation of thermoplastic resin

40 g of n-butyl acrylate, 25 g of ethyl acrylate, 30 g of acrylonitrile, and 5 g of glycidyl methacrylate were added to 100 g of toluene. Then, the obtained reaction product was reacted at 80°C for about 12 hours to synthesize an acrylate-based resin into which a glycidyl group was introduced (weight average molecular weight: about 500,000, glass transition temperature: 40°C).

Preparation Example 3: Preparation of thermoplastic resin

40 g of butyl acrylate, 30 g of acrylonitrile, 5 g of glycidyl methacrylate, and 25 g of styrene were added to 100 g of toluene. Then, the obtained reaction product was reacted at 80°C for about 12 hours to synthesize an acrylate-based resin into which a glycidyl group was introduced (weight average molecular weight: about 700,000, glass transition temperature: 63°C).

Preparation Example 4: Preparation of thermoplastic resin

35 g of a phenoxy resin (Kukdo Chemical YP-50, weight average molecular weight: about 55,000, glass transition temperature: 80~83°C) was dissolved in 65 g of toluene to prepare a thermoplastic resin.

Example 1: Manufacturing of non-conductive film and semiconductor device

(1) Preparation of adhesive composition

The components listed in Table 1 below were added to methyl ethyl ketone in the amounts shown in Table 1, and mixed to prepare an adhesive composition (solid content: 50 wt.%).

(2) Manufacturing of non-conductive film

The adhesive composition was applied onto a release-treated polyethylene terephthalate film (thickness 38 $\mu$m) using a comma coater, and then dried at 110°C for 3 minutes to form a B-staged adhesive layer having a thickness of about 20 $\mu$m.

(3) Manufacturing of semiconductor device

A semiconductor element having a plurality of silicon through electrodes was prepared. Bumps in which lead-free solders (SnAgCu) were formed to a height of 3 $\mu$m on copper fillers having a height of 15 $\mu$m and a pitch of 50 $\mu$m were formed in the semiconductor element.

The non-conductive film was positioned so that the adhesive layer was in contact with the bump-formed surface thereof, and then vacuum lamination was performed at 80°C. Then, the polyethylene terephthalate film was peeled off from the adhesive layer.

Subsequently, the substrate and the semiconductor element were arranged so that the bumps of the semiconductor element were positioned on the connection pad of the substrate having connection pads with a pitch of 50 $\mu$m. Then, using a thermocompression bonder, the laminate of the substrate and semiconductor element was pressed with 100 N for 3 seconds at 70°C, and then heated to 260°C for 4 seconds to perform thermocompression bonding.

Examples 2 to 4 and Comparative Examples 1 to 3: Manufacturing of non-conductive film and semiconductor device

An adhesive composition, a non-conductive film, and a semiconductor device were manufactured in the same manner as in Example 1, except that the composition of the adhesive composition of Example 1 was changed as shown in Table 1 below.

[Table 1]

| | | Example 1 | Example 2 | Example 3 | Example 4 | Comparative Example 1 | Comparative Example 2 | Comparative Example 3 |
|---|---|---|---|---|---|---|---|---|
| Thermoplastic resin | Preparation Example 1 | 5 | 5 | | | 10 | | 5 |
| | Preparation Example 2 | | | 5 | 5 | | 10 | 5 |
| | Preparation Example 3 | 5 | | 5 | | | | |
| | Preparation Example 4 | | 5 | | 5 | | | |
| Thermosetting resin | RE-310S | 10 | 10 | 10 | 10 | 10 | 10 | 10 |
| | EOCN-1020-70 | 15 | 15 | 15 | 15 | 15 | 15 | 15 |
| Curing agent | KA-1165 | 15 | 15 | 15 | | 15 | 15 | 15 |
| | GPH-103 | | | | 15 | | | |

(continued)

| | | Example 1 | Example 2 | Example 3 | Example 4 | Comparative Example 1 | Comparative Example 2 | Comparative Example 3 |
|---|---|---|---|---|---|---|---|---|
| Inorganic filler | SC-2050 | 45 | 45 | 45 | 45 | 45 | 45 | 45 |
| Curing catalyst | 2P4MH Z | 4 | 4 | 4 | 4 | 4 | 4 | 4 |
| Coupling agent | KBM-403 | 1 | 1 | 1 | 1 | 1 | 1 | 1 |

The content (parts by weight) in Table 1 is the solid content.

RE-310S: liquid epoxy resin (Nippon Kayaku Co., Ltd., bisphenol A type epoxy resin, epoxy equivalent weight 180 g/eq)

EOCN-1020-70: solid epoxy resin (Nippon Kayaku Co., Ltd., cresol novolac type epoxy resin, epoxy equivalent weight 199 g/eq, softening point: 70°C)

KA-1165: phenol resin (manufactured by DIC, bisphenol A novolac resin, hydroxyl equivalent weight 119 g/eq, softening point: 125°C)

GPH-103: phenol resin (Nippon Kayaku Co., Ltd., hydroxyl equivalent weight 230 g/eq, softening point: 103°C)

SC-2050: spherical silica, Admatec, average particle size about 400 nm

2P4MHZ: 2-phenyl-4-methyl-5-hydroxymethylimidazole

KBM-403: silane coupling agent (manufactured by Shin-Etsu, 3,3-glycidoxypropyl trimethoxysilane)

Test example: Evaluation of physical properties of non-conductive film and performance of semiconductor device

(1) Difference between the heat generation start temperature and the maximum heat generation temperature of the adhesive layer ($\triangle$T)

The heat generation start temperature and the maximum heat generation temperature of the adhesive layer were determined by differential scanning calorimetry (DSC). The DSC analysis was conducted at a temperature increase rate of 10 °C/min and a temperature range from 30°C to 300°C.
As a result of the DSC analysis, a thermal analysis chart was obtained in which the horizontal axis was represented by temperature and the vertical axis was represented by heat flow. In the thermal analysis chart, the starting point (onset) where the extension line of the heat generation peak met the baseline was defined as the heat generation start temperature, and the apex of the heat generation peak was defined as the maximum heat generation temperature.

(2) Gel time (G) of the adhesive layer

The gel time of the B-staged adhesive layer was measured on a hot plate at 200°C. Specifically, the adhesive layers were overlapped and laminated until the thickness reached 120 $\mu$m, and then pressed using a roll laminator at 60°C. The test piece thus obtained was cut into a circle with a diameter of 10 mm. The cut test piece was placed on a hot plate at 200°C, and stirred with a stirring bar so that a small circle was drawn on the surface of the test piece. Stirring was continued until the test piece increased in viscosity and eventually gelled, losing fluidity. The time from the time point when the test piece was placed on the hot plate until the test piece gelled and lost its fluidity was measured in seconds. Such measurements were performed twice, and if the difference between the two measured values was within 10% of the lower value of the measured values, the gel time was recorded as the average value of the two measurements, and if it exceeded 10%, measurements were performed three times, and the gel time was recorded as the average value of the three measurements.

(3) Minimum melt viscosity (η) of the adhesive layer

The adhesive layers were overlapped and laminated until the thickness reached 400 $\mu$m, and then pressed using a roll laminator at 60°C. The test piece thus obtained was cut into a circle with a diameter of 20 mm. The viscosity of the cut test piece was measured under the conditions of 1000 Pa and a temperature increase rate of 10°C/min using MARS equipment from HAKKE. The lowest viscosity value among the measured viscosity values was defined as the minimum melt viscosity.

(4) Mold Void Test

Through IR MicroScope, it was evaluated as acceptable (∘) if the area occupied by the void between the semiconductor element and the substrate is 3% or less, and as unacceptable (x) if the area exceeds 3%.

(5) Evaluation of conduction

The semiconductor device was evaluated as acceptable (∘) if the daisy chain connection could be confirmed, and as unacceptable (x) if the daisy chain connection could not be confirmed.

(6) Evaluaiton of connection state

The semiconductor device was polished so that the cross section of the connecting portion was exposed, and the exposed cross section of the connecting portion was observed using an optical microscope. If no trap of the adhesive composition was seen in the connecting portion and the solder was sufficiently wetted on the wiring, it was evaluated as acceptable (∘), and otherwise, it was evaluated as unacceptable (x).

(7) Evaluation of fillet void

After connecting the semiconductor device through the thermocompression bonding process, the fillet formed at the edge of the semiconductor element is confirmed using an IR Microscope, and it was evaluated as acceptable (O) if there were no voids with a fillet inner diameter of 1 $\mu$m or more, and as unacceptable (x) if there were voids in the fillet with a diameter of 1 $\mu$m or more.

[Table 2]

| | | Example 1 | Example 2 | Example 3 | Example 4 | Comparative Example 1 | Comparative Example 2 | Comparative Example 3 |
|---|---|---|---|---|---|---|---|---|
| Non-conductive film | ΔT (°C) | 8 | 8 | 8 | 8 | 8 | 8 | 8 |
| | G (sec) | 7.5 | 8.1 | 7.8 | 8.0 | 8.2 | 8.7 | 8.4 |
| | η (Pa·s) | 480 | 410 | 610 | 450 | 180 | 240 | 210 |
| | Y | 1.28 | 1.74 | 1.09 | 1.55 | 4.07 | 3.43 | 3.66 |
| Semiconductor device | Void evaluation | ○ | ○ | ○ | ○ | × | × | × |
| | Conduction evaluation | ○ | ○ | ○ | ○ | × | × | × |
| | Connection status evaluation | ○ | ○ | ○ | ○ | × | × | × |
| | Fillet void evaluation | ○ | ○ | ○ | ○ | × | × | × |

In Table 2, Y is a value calculated by Equation 1 mentioned above.
Referring to Table 2, it is confirmed that in the case of Examples 1 to 4 where Y calculated by Equation 1 is 3 or less, it is possible to suppress generation of voids between the substrate and the semiconductor element or in fillets formed at the edges of the semiconductor element, thereby providing a semiconductor device having excellent metal connection state. On the other hand, it is confirmed that in the case of Comparative Examples 1 to 3 where Y calculated by Equation 1 exceeds 3, voids are generated between the substrate and the semiconductor element and in the fillet formed at the edge of the semiconductor element, resulting in poor metal connection state.

**Claims**

1. A non-conductive film, comprising:

   an adhesive layer comprising a thermoplastic resin, a thermosetting resin, a curing agent and an inorganic filler, wherein the adhesive layer has a Y of the following Equation 1 that is more than 0 and 3 or less:

$$[\text{Equation 1}]$$

$$Y = (\triangle T * G)^2/(5.88 * \eta)$$

   wherein, in Equation 1,
   $\triangle T$ is the difference between the heat generation start temperature and the maximum heat generation temperature of the adhesive layer measured by differential scanning calorimetry at a temperature increase rate of 10°C/min and a temperature of 30°C to 300°C, G is the gelling time at 200°C measured in seconds for the adhesive layer, and $\eta$ is the minimum melt viscosity measured in units of Pa·s for the adhesive layer.

2. The non-conductive film of claim 1, wherein $\triangle T$ in Equation 1 is between 1°C and 20°C.

3. The non-conductive film of claim 1, wherein G in Equation 1 is between 5 seconds and 30 seconds.

4. The non-conductive film of claim 1, wherein $\eta$ in Equation 1 is between 10 Pa·s and 5000 Pa·s.

5. The non-conductive film of claim 1, wherein the thermoplastic resin includes two or more types of thermoplastic resins having different glass transition temperatures.

6. The non-conductive film of claim 1, wherein the thermoplastic resin includes a first thermoplastic resin having a glass transition temperature of -10°C to 50°C and a second thermoplastic resin having a glass transition temperature of more than 50°C and 100°C or less.

7. The non-conductive film of claim 6, wherein the first thermoplastic resin includes a first copolymer produced from an alkyl (meth)acrylate having 1 to 12 carbon atoms, a (meth)acrylate containing an epoxy group, and acrylonitrile.

8. The non-conductive film of claim 6, wherein the second thermoplastic resin includes a second copolymer produced from an alkyl (meth)acrylate having 1 to 12 carbon atoms, a (meth)acrylate containing an epoxy group, acrylonitrile, and styrene; or one or more phenoxy-based resins selected from the group consisting of bisphenol A-type phenoxy resin, bisphenol F-type phenoxy resin, bisphenol A/F-type phenoxy resin, and fluorene-based phenoxy resin.

9. The non-conductive film of claim 6, wherein the first and second thermoplastic resins are included in a weight ratio of 1:10 to 1:0.1.

10. The non-conductive film of claim 1, wherein the thermosetting resin includes a liquid epoxy resin and a solid epoxy resin.

11. A semiconductor device comprising the non-conductive film of claim 1 and a semiconductor element, wherein the semiconductor element is embedded by the adhesive layer.

12. The semiconductor device of claim 11, wherein the semiconductor element includes a bump.

13. A method of manufacturing a semiconductor device, the method comprising the steps of:

    calculating Y in the following Equation 1 for a non-conductive film containing an adhesive layer and selecting the non-conductive film containing an adhesive layer in which Y is more than 0 and 3 or less; and

applying the selected non-conductive film to an element formation surface of a semiconductor element:

[Equation 1]

$$Y = (\triangle T * G)^2/(5.88 * \eta)$$

wherein, in Equation 1,

$\triangle T$ is the difference between the heat generation start temperature and the maximum heat generation temperature of the adhesive layer measured by differential scanning calorimetry at a temperature increase rate of 10°C/min and a temperature of 30°C to 300°C, G is the gelling time at 200°C measured in seconds for the adhesive layer, and $\eta$ is the minimum melt viscosity measured in units of Pa·s for the adhesive layer.

<div style="text-align:center">**INTERNATIONAL SEARCH REPORT**</div>

| | |
|---|---|
| International application No. |
| **PCT/KR2023/017806** |

**A.     CLASSIFICATION OF SUBJECT MATTER**

**C09J 163/00**(2006.01)i; **C09J 11/04**(2006.01)i; **C08L 61/04**(2006.01)i; **C08L 33/20**(2006.01)i; **C08L 71/00**(2006.01)i; **H01L 21/683**(2006.01)i

According to International Patent Classification (IPC) or to both national classification and IPC

**B.     FIELDS SEARCHED**

Minimum documentation searched (classification system followed by classification symbols)

C09J 163/00(2006.01); C08L 37/00(2006.01); C09J 7/00(2006.01); C09J 7/35(2018.01); H01L 21/52(2006.01); H01L 25/065(2006.01); H01L 25/18(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 열가소성 수지(thermoplastic resin), 열경화성 수지(thermoset resin), 경화제 (hardener), 무기 충전제(inorganic filler), 비전도성 필름(non-conductive film)

**C.     DOCUMENTS CONSIDERED TO BE RELEVANT**

| Category* | Citation of document, with indication, where appropriate, of the relevant passages | Relevant to claim No. |
|---|---|---|
| Y | KR 10-1435758 B1 (INNOX CORPORATION) 29 August 2014 (2014-08-29)<br>    See claims 1 and 12-14; and paragraphs [0090]-[0159]. | 1-13 |
| Y | KR 10-2021-0096591 A (SHOWA DENKO MATERIALS CO., LTD.) 05 August 2021 (2021-08-05)<br>    See claims 1 and 2. | 1-13 |
| Y | US 4975484 A (FRYD, M. et al.) 04 December 1990 (1990-12-04)<br>    See abstract; claim 1; and column 5, lines 1-60. | 7 |
| A | KR 10-2020-0020666 A (HITACHI CHEMICAL COMPANY, LTD.) 26 February 2020 (2020-02-26)<br>    See entire document. | 1-13 |
| A | JP 2010-001453 A (HITACHI CHEM. CO., LTD.) 07 January 2010 (2010-01-07)<br>    See entire document. | 1-13 |

☐ Further documents are listed in the continuation of Box C.          ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **07 February 2024** | **07 February 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

<div style="text-align:center">13</div>

INTERNATIONAL SEARCH REPORT
Information on patent family members

International application No.

**PCT/KR2023/017806**

| Patent document cited in search report | | | Publication date (day/month/year) | Patent family member(s) | | | Publication date (day/month/year) |
|---|---|---|---|---|---|---|---|
| KR | 10-1435758 | B1 | 29 August 2014 | None | | | |
| KR | 10-2021-0096591 | A | 05 August 2021 | CN | 113169141 | A | 23 July 2021 |
| | | | | JP | 2021-110785 | A1 | 14 October 2021 |
| | | | | JP | 7384171 | B2 | 21 November 2023 |
| | | | | TW | 202028391 | A | 01 August 2020 |
| | | | | TW | I807135 | B | 01 July 2023 |
| | | | | WO | 2020-110785 | A1 | 04 June 2020 |
| US | 4975484 | A | 04 December 1990 | EP | 201102 | A2 | 12 November 1986 |
| | | | | EP | 201102 | A3 | 01 April 1987 |
| | | | | EP | 201102 | B1 | 29 August 1990 |
| | | | | JP | 05-279635 | A | 26 October 1993 |
| | | | | JP | 61-261307 | A | 19 November 1986 |
| | | | | US | 4980410 | A | 25 December 1990 |
| KR | 10-2020-0020666 | A | 26 February 2020 | JP | 2020-235854 | A1 | 23 April 2020 |
| | | | | JP | 7196841 | B2 | 27 December 2022 |
| | | | | KR | 10-2491834 | B1 | 25 January 2023 |
| | | | | TW | 201906956 | A | 16 February 2019 |
| | | | | WO | 2018-235854 | A1 | 27 December 2018 |
| JP | 2010-001453 | A | 07 January 2010 | None | | | |

Form PCT/ISA/210 (patent family annex) (July 2022)

# EP 4 474 442 A1

**REFERENCES CITED IN THE DESCRIPTION**

**Patent documents cited in the description**

- KR 1020230050688